# EUROPEAN PATENT APPLICATION

(11) **EP 4 203 082 A1**
(43) Date of publication of application: **28.06.2023**
(21) Application number: 21882648.5
(22) Date of filing: 11.10.2021
(51) Int. Cl.: H01L 33/60

(54) **SEMICONDUCTOR LIGHT EMITTING DEVICE AND SEMICONDUCTOR LIGHT EMITTING MODULE**

(30) Priority: 22.10.2020 JP 2020177496
(71) Applicant: STANLEY ELECTRIC CO., LTD., Tokyo 153-8636 (JP)
(72) Inventor: KONO ,Keima, Tokyo 153-8636 (JP); ICHIKAWA, Koji, Tokyo 153-8636 (JP); KAMBARA, Daizo, Tokyo 153-8636 (JP); HORIO, Naochika, Tokyo 153-8636 (JP)
(74) Representative: Schmidbauer, Andreas Konrad
(86) International application number: PCT/JP2021/037616
(87) International publication number: WO 2022/085507

(57) **Abstract**

A semiconductor light emitting device includes: a light emitting element assembly including a semiconductor light emitting element including a support substrate and a light emitting semiconductor layer provided on the support substrate, and a light guide member adhered to the semiconductor light emitting element by an element adhesive layer; and a first coating film adhered to a side surface of the light emitting element assembly by a side wall adhesive layer and formed of an inorganic material, which is a light reflector configured to cover the side surface.

## Description

### Technical Field

The present invention relates to a semiconductor light emitting device and a semiconductor light emitting module, and more specifically, to a semiconductor light emitting device having semiconductor light emitting elements such as light emitting diodes (LEDs) and semiconductor light emitting modules.

### Background Art

In recent years, semiconductor light emitting elements such as light emitting diodes (LEDs) are arranged and used in a plurality of devices in order to increase an output or control light distribution.

For example, among vehicle headlights, an adaptive driving beam (ADB) that controls light distribution according to a traveling environment is known. In addition, an LED package for high-output illumination, an LED package for an information communication device in which LEDs are arranged at high density, or the like is known.

However, in a semiconductor light emitting device in which a plurality of semiconductor light emitting elements are arranged side by side, a part of light emitted from a conductive element may generally propagate through a non-conductive element. Such leakage light or crosstalk of light arises as a problem in various application fields in which the plurality of semiconductor light emitting elements are arranged and used.

For example, Patent Literature 1 discloses that optical reflection layers are provided on side surfaces of a substrate and a light emitting element. In addition, Patent Literature 2 discloses a light emitting element that includes a reflection member covering side surfaces of a semiconductor stacked body and suppressing light leakage to sides from an upper end of the side surface of the semiconductor stacked body.

Patent Literature 3 discloses a semiconductor light emitting device including a light reflection groove that suppresses crosstalk between light emitting segments.

### Citation List

### Patent Literature

Patent Literature 1: Japanese Patent Application Laid-Open No. 2015-225862
Patent Literature 2: Japanese Patent Application Laid-Open No. 2015-119063
Patent Literature 3: Japanese Patent Application Laid-Open No. 2015-156431

### Summary of Invention

### Technical Problem

The present invention has been made in view of the above-described points, and an object of the present invention is to provide a semiconductor light emitting device with high reliability and excellent airtightness, in which incidence of light leaking to the outside and external light is extremely suppressed. In addition, another object of the present invention is to provide a semiconductor light emitting module having high contrast and excellent light shielding property, airtightness, fixing property, and reliability, in which crosstalk of light between adjacent light emitting devices is extremely suppressed.

### Solution to Problem

A semiconductor light emitting device according to a first embodiment of the present invention includes:
a light emitting element assembly including a semiconductor light emitting element including a support substrate and a light emitting semiconductor layer provided on the support substrate, and a light guide member adhered to the semiconductor light emitting element by an element adhesive layer; and
a first coating film adhered to a side surface of the light emitting element assembly by a side wall adhesive layer and formed of an inorganic material, which is a light reflector configured to cover the side surface.

### Brief Description of Drawings

FIG. 1A is a plan view schematically illustrating an upper surface of a semiconductor light emitting device 10 according to a first embodiment of the present invention.
FIG. 1B is a sectional view schematically illustrating a cross section of the semiconductor light emitting device 10 taken along line A-A of FIG. 1A.
FIG. 1C is a plan view schematically illustrating a back surface of the semiconductor light emitting device 10.
FIG. 1D is a partially enlarged sectional view illustrating an enlarged adhesive portion W of a light guide member 13 and an inner coating film 14.
FIG. 2 is a sectional view schematically and detailedly illustrating an example of a configuration of an LED element 11, which is a semiconductor light emitting element.
FIG. 3A is a view describing a manufacturing method of the semiconductor light emitting device 10 when the inner coating film 14 is an alumina plate.
FIG. 3B is a view describing a manufacturing method of the semiconductor light emitting device 10 when the inner coating film 14 is an alumina plate.
FIG. 3C is a view describing a manufacturing method of the semiconductor light emitting device 10 when the inner coating film 14 is an alumina plate.
FIG. 4A is a view describing a manufacturing method of the semiconductor light emitting device 10 when the inner coating film 14 is a dielectric multilayer film.
FIG. 4B is a view describing a manufacturing method of the semiconductor light emitting device 10 when the inner coating film 14 is a dielectric multilayer film.
FIG. 4C is a view describing a manufacturing method of the semiconductor light emitting device 10 when the inner coating film 14 is a dielectric multilayer film.
FIG. 5A is a top view illustrating a semiconductor light emitting module 37 in which semiconductor light emitting devices are arranged in a 5 x 3 arrangement.
FIG. 5B is a sectional view illustrating a cross section taken along line A-A in FIG. 5A and schematically illustrating an application example of the semiconductor light emitting device 10 according to the present embodiment.
FIG. 5C is sectional views schematically illustrating cross sections of a semiconductor light emitting module 38 of Comparative Examples 1 and 2.
FIG. 5D is a view schematically illustrating a difference in a light emitting display pattern between the semiconductor light emitting module 37 used in the semiconductor light emitting device 10 of the present embodiment and the semiconductor light emitting module 38 used in semiconductor light emitting devices 90 of Comparative Examples 1 and 2.
FIG. 6 is a sectional view schematically illustrating a cross section of a semiconductor light emitting device 50 according to a second embodiment of the present invention.
FIG. 7A is a sectional view schematically illustrating a cross section of a semiconductor light emitting device 60 according to a third embodiment of the present invention.
FIG. 7B is a top view schematically illustrating the semiconductor light emitting device 60 when viewed from above.
FIG. 8 is a sectional view schematically illustrating a cross section of a semiconductor light emitting device 70 according to a fourth embodiment of the present invention.

### Description of Embodiments

While the present invention is described below in terms of the presently preferred embodiments, appropriate modifications or combinations thereof may be applied. In addition, in the following description and the appended drawings, parts which are substantially identical or equivalent have been assigned identical reference symbols in the description.

### [First Embodiment]

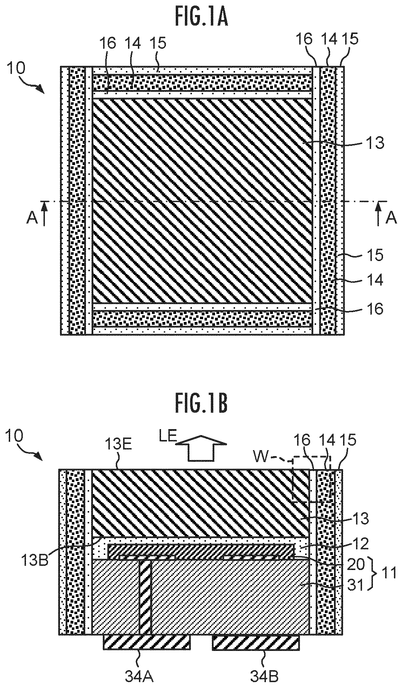

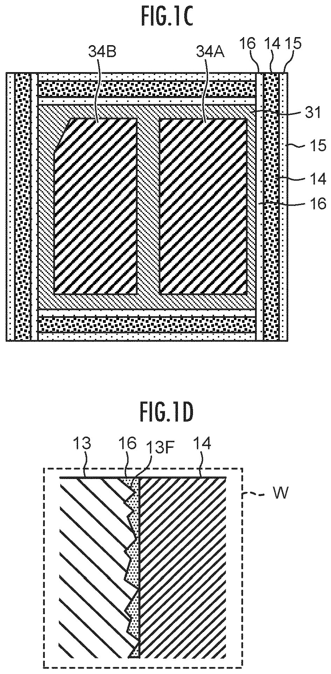

FIG. 1A is a plan view schematically illustrating an upper surface of a semiconductor light emitting device 10 according to a first embodiment of the present invention. FIG. 1B is a sectional view schematically illustrating a cross section of the semiconductor light emitting device 10 taken along line A-A of FIG. 1A. FIG. 1C is a plan view schematically illustrating a back surface of the semiconductor light emitting device 10.

The semiconductor light emitting device 10 includes a semiconductor light emitting element 11 and a light guide member 13 adhered onto the semiconductor light emitting element 11 by an element adhesive layer 12 formed of an adhesive. In addition, the semiconductor light emitting device 10 includes an inner coating film 14 and an outer coating film 15, which cover side surfaces of the semiconductor light emitting element 11 and light guide member 13.

As illustrated in FIGS. 1A to 1C, the semiconductor light emitting element 11 includes a light emitting semiconductor layer 20 provided on a support substrate 31. Although a light emitting diode (LED) will be described below as the semiconductor light emitting element 11 by way of example, a surface light emitting element such as a surface light emitting laser diode (LD) may be provided.

In the present embodiment, the support substrate 31 and light guide member 13 of the semiconductor light emitting element (hereinafter referred to as an LED element) 11, which is a light emitting diode (LED), have a rectangular shape. The side surfaces of the LED element 11, the element adhesive layer 12 (hereinafter simply referred to as an adhesive layer 12), and the light guide member 13 are commonly covered by the inner coating film 14 (first coating film) and the outer coating film 15 (second coating film) formed in close contact with the outside of the inner coating film 14.

More specifically, the inner coating film 14 (first coating film) is adhered to the LED element 11, the element adhesive layer 12, and the light guide member 13 by a side wall adhesive layer 16 (hereinafter simply referred to as an adhesive layer 16). The LED element 11, the element adhesive layer 12, and the light guide member 13 are preferably sealed by the side wall adhesive layer 16.

The light guide member 13 has a size and arrangement such that the light guide member 13 includes the LED semiconductor layer 20 when viewed in the vertical direction of the LED semiconductor layer 20 (hereinafter referred to as when viewed from above).

FIG. 1D is a partially enlarged sectional view illustrating a part shown as W in FIG. 1B, that is, an enlarged adhesive portion W of the light guide member 13 and the inner coating film 14 by the side wall adhesive layer 16.

More specifically, the light guide member 13 and/or the LED element 11 is cut by dicing or the like and the side surface thereof has fine irregularities. As illustrated in FIG. 1D, the side wall adhesive layer 16 is formed to fill a space between the irregularities of a side surface 13F of the light guide member 13 and the inner coating film 14.

Further, the inner coating film 14 adheres along a top of the side surface 13F of the light guide member 13. Therefore, light leakage from an upper end of a light emission surface 13E side is significantly suppressed by guiding light into the side wall adhesive layer 16. In addition, the irregularities between the inner coating film 14 and the light guide member 13 are filled with the side wall adhesive layer 16, so that the inner coating film 14 is firmly fixed to the light guide member 13. The same applies to an adhesive surface between the support substrate 31 and the inner coating film 14, and the light leakage is sufficiently suppressed and the support substrate 31 is firmly fixed to the inner coating film 14.

In the present embodiment, an alumina plate and aluminum/titanium-tungsten (Al/TiW) are used as the inner coating film (first coating film) 14 and the outer coating film (second coating film) 15, respectively.

Alternatively, a dielectric multilayer film and aluminum (Al) are used as the inner coating film (first coating film) 14 and the outer coating film (second coating film) 15, respectively.

When the inner coating film 14 is formed of ceramic, a transparent resin or a white resin can be used for the side wall adhesive layer 16. In addition, when the inner coating film 14 is a dielectric multilayer film, a transparent resin can be used.

The inner coating film (first coating film) 14 has light reflectivity, insulation property and airtightness, and the outer coating film (second coating film) 15 has light shielding property due to the light reflectivity or light absorbing property. That is, a stacked structure of the inner coating film 14 and the outer coating film 15 achieves both a high reflectivity for light from the inside of the coating film and a high light shielding property for light from the outside of the coating film.

A light-reflective white alumina-ceramic binder is used for the inner coating film 14. The ceramic binder is a dense white coating film in which particles forming the coating film is bonded to each other, and has a thickness of about several tens of µm and sufficient light reflectivity. Such an inner coating film 14 efficiently reflects light directed from the light guide member 13 toward the inner coating film 14.

The inner coating film 14 and the outer coating film 15 preferably cover the entire side surface of a light emitting element assembly 11A in which the LED element 11, the element adhesive layer 12 (hereinafter simply referred to as the adhesive layer 12), and the light guide member 13 are formed integrally. In addition, it is preferable that the adhesive layer 12 is filled between the semiconductor light emitting element 11 and the light guide member 13.

As the inner coating film 14, a light-reflective ceramic binder such as white alumina, zirconia, magnesia, or titanium oxide or a light-reflective composite ceramic binder such as white alumina-zirconia can be used. In addition, a silicate-based binder formed of a metal silicate-based inorganic adhesive can be used, as an aggregate, with mixed particles of light-reflective ceramic particles having a reflectivity similar to the ceramic binder, such as white alumina, zirconia, and magnesia, or white light-reflective ceramic particles. The silicate-based binder is formed by producing a siloxane bond (Si-O-Si) due to heating around 100°C after applying the inorganic adhesive. The silicate-based binder has heat resistance at around 1,000°C and excellent weather resistance.

In addition, white alumina is alumina-based fine ceramic used for a manufacturing device of a semiconductor or liquid crystal, and has a color tone of white or ivory. In addition, a light-reflective composite ceramic binder such as white alumina-zirconia has higher reflectivity than a single ceramic binder because reflection characteristics at interfaces between alumina particles and zirconia particles having different refractive indices are improved. In addition, a component ratio is adjusted, such that it is possible to match a coefficient of linear thermal expansion of the light emitting element assembly 11A and to suppress the occurrence of cracks or the like in the inner coating film 14.

A light reflective or light shielding metal film can be used for the outer coating film 15. For example, a metal film formed on the inner coating film 14 by vapor depositing, sputtering, or the like can be used.

Alternatively, a dielectric multilayer film can be formed on the outer coating film 15 such as a metal film and a ceramic plate by vapor deposition, sputtering, or the like to form the inner coating film 14.

In addition, as the outer coating film 15, the light-absorptive ceramic binder such as black alumina, zirconia, silicon nitride, and titanium carbide can be used. Alternatively, a corrosion-resistant metal coating film such as cermet, or a metal coating film having a passive film, which is a reflective metal such as an aluminum alloy or stainless steel (SUS) and is formed of an oxide film of a metal contained in a surface thereof, can be used. In addition, a silicate-based binder can be used, as an aggregate, with a mixture of light-absorptive ceramic particles similar to the ceramic binder, such as black alumina, zirconia, silicon nitride, and titanium carbide, or light-absorptive ceramic particles.

More specifically, examples of the black alumina include black alumina (AR(B)) (manufactured by ASUZAC Inc.) having a black color tone, so that it is possible to suppress a surface reflection while maintaining a strength and durability, which are features of fine ceramics (the reflectivity is 5.1% to 15.3% at a wavelength of 240 to 2,600 nm).

Further, examples of the black ceramic other than alumina include NPZ-96 (black zirconia), NPA-2 (black alumina + titanium carbide), NPN-3 (black silicon nitride), and the like which are manufactured by Nippon Tungsten Co., Ltd.

The outer coating film 15 may be omitted in applications that do not require light shielding and corrosion resistance provided by the outer coating film 15.

The light guide member 13 also functions as a sealing material on an upper surface side of the semiconductor light emitting device 10. Light emitted from the LED element 11 is incident on the light guide member 13 from a bottom surface 13B of the light guide member 13, emission light LE of the semiconductor light emitting device 10 is emitted from a surface of the light guide member 13 (light emission surface 13E).

As the light guide member 13, a ceramic phosphor plate containing a transparent glass plate, a sapphire plate, a resin plate, or a wavelength conversion member and formed of alumina + YAG:Ce and the like, a glass phosphor plate formed of glass + α or β sialon and the like, a resin phosphor plate formed of silicone resin + silicate:Ce and the like, and a monocrystalline or polycrystalline single crystal phosphor plate formed of YAG + Ce and the like, can be used.

As the element adhesive layer 12, a resin, a low-melting-point glass, a nanometal oxide sintered body, or the like, which transmits light emitted by the LED element 11, can be used. In addition, a composite or the like, which is obtained by impregnating a porous nanometal oxide sintered body with the resin or low-melting-point glass, can also be used. In addition, a diffusing agent and a light conversion member can be additionally provided in the adhesive layer 12.

An anode electrode 34A and a cathode electrode 34B are provided on the back surface of the semiconductor light emitting device 10, and function as external electrodes of the semiconductor light emitting device 10.

### (1) Configuration of LED Element 11

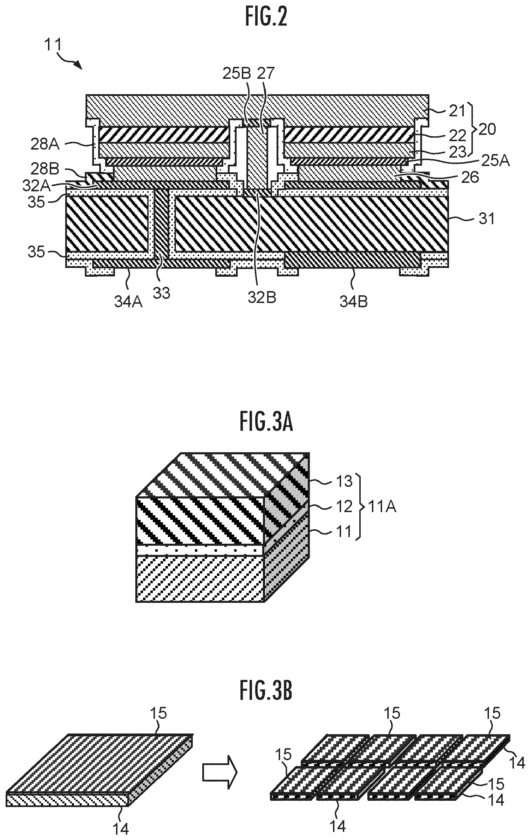

FIG. 2 is a sectional view schematically and detailedly illustrating an example of a configuration of an LED element 11, which is a semiconductor light emitting element. The LED element 11 has a configuration in which an LED semiconductor layer 20, which is a so-called thin-film LED, is attached to the support substrate 31 as the light emitting semiconductor layer 20.

More specifically, the LED semiconductor layer (light emitting semiconductor layer) 20 has a configuration in which a semiconductor layer (thin-film LED) having an LED structure epitaxially grown on a growth substrate is removed from the growth substrate and attached to the support substrate 31. In the present embodiment, a p-type semiconductor layer, which is a growth superficial layer, is attached to the support substrate 31 as a lower surface, and an n-type semiconductor layer refers to a surface layer.

The support substrate 31 is an n-type substrate formed of silicon (Si) doped with phosphorous (P), arsenide (As), or the like.

The LED semiconductor layer 20 includes an n-type semiconductor layer 21, a light emitting layer 22, and a p-type semiconductor layer 23. Each of the n-type semiconductor layer 21 and the p-type semiconductor layer 23 is formed of at least one semiconductor layer, and may include various semiconductor layers such as a barrier layer, a current diffusion layer, and a contact layer.

The LED semiconductor layer 20 is, for example, a blue light emitting LED semiconductor layer formed of a GaN-based semiconductor layer, but is not limited thereto. The light emitting layer 22 has, for example, a single quantum well (SQW) or multiple quantum well (MQW) structure.

The LED semiconductor layer 20 has a p-electrode 25A and an n-electrode 25B. The p-electrode 25A is bonded to a p-side substrate electrode 32A by a conductive p-side bonding layer 26, and the n-electrode 25B is bonded to an n-side substrate electrode 32B by a conductive n-side bonding layer 27.

The p-electrode 25A is formed of an ITO/Ni/Pt/Ag layer in which indium tin oxide (ITO), nickel (Ni), platinum (Pt), and silver (Ag) reflective films are sequentially formed on the p-type semiconductor layer 23. The n-electrode 25B is formed of a (Ti or Ni)/Pt/Au layer in which titanium (Ti) or nickel (Ni), platinum (Pt), and gold (Au) are sequentially formed on the n-type semiconductor layer 21.

The materials and structures of the p-electrode 25A and the n-electrode 25B are not limited to the above. The materials and structures thereof can be appropriately selected in consideration of characteristics such as extraction efficiency improvement by light reflection, ohmic characteristics, and element reliability (lifespan).

An element protective film 28A formed of SiO2 is provided on a side surface of the LED semiconductor layer 20. In addition, a substrate protective film 28B formed of SiO2 is provided on a surface of the support substrate 31 (a side bonded to the LED semiconductor layer 20).

The p-side substrate electrode 32A is connected to a conductive via 33 and is electrically connected to the anode electrode 34A on the back surface of the semiconductor light emitting device 10 through the conductive via 33. The p-side substrate electrode 32A, the conductive via 33, and the anode electrode 34A are insulated from the support substrate 31 by a substrate insulating film 35 formed of SiO2.

The n-side substrate electrode 32B is electrically connected to the cathode electrode 34B on the back surface of the semiconductor light emitting device 10 through the support substrate 31 which is a Si substrate.

### (2) Manufacturing Method of Semiconductor Light Emitting Device 10

A manufacturing method of the semiconductor light emitting device 10 will be described below with reference to FIGS. 3A to 3C. First, as illustrated in FIG. 3A, the LED element 11 and the light guide member 13 are prepared.

An adhesive formed of a transparent silicone resin is potted on an upper surface (light emission surface) of the LED element 11. Subsequently, the light guide member 13 is placed on the LED element 11 and pressed (including self-weight pressing). The adhesive is allowed to stand until it is filled between an outer periphery of an upper end of the LED element 11 and an outer periphery of a lower end of the light guide member 13.

The adhesive is cured by performing a heat treatment at 180°C for 30 minutes in an oven to form the adhesive layer 12. As a result, a light emitting element assembly (hereinafter referred to as an LED assembly) 11A in which the LED element 11, the adhesive layer 12 and the light guide member 13 are formed integrally is formed.

Next, as illustrated in FIG. 3B, aluminum/titanium-tungsten (Al/TiW), which is the outer coating film 15, is vapor-deposited to an alumina plate having a thickness of 100 µm, which is the inner coating film 14 (left side of FIG. 3B). Next, the alumina surface is wrapped to make the thickness of the alumina plate 50 µm.

Subsequently, a coating plate 17 (ceramic plate) is formed by dicing according to a size of the side wall of an LED assembly 11A (right side of FIG. 3B). A plurality of coating plates 17 having a plurality of sizes according to side walls with different sizes can be formed by dicing, as in a case where the LED assembly 11A has a rectangular shape or the like.

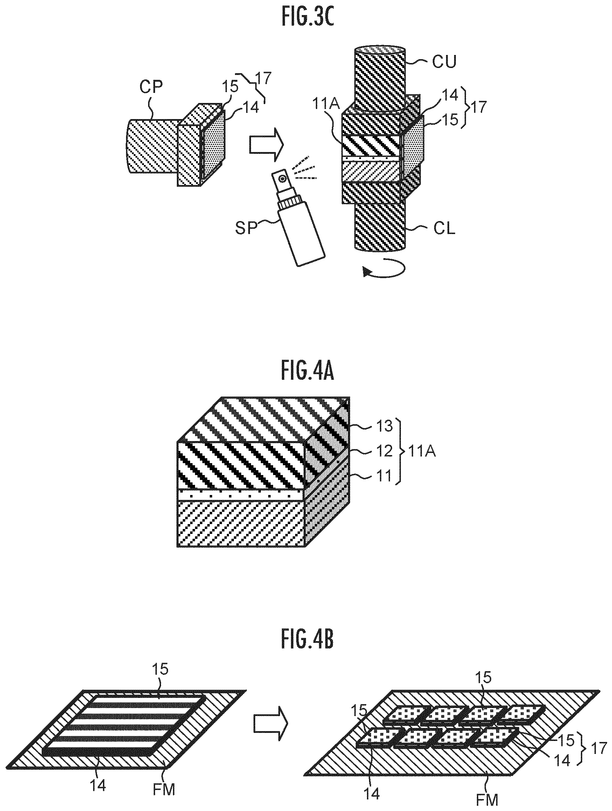

Next, as illustrated in FIG. 3C, the LED assembly 11A is set between an upper chuck CU and a lower chuck CL having substantially the same shape and size as a top surface of the light guide member 13 and a bottom surface of the LED element 11, respectively. Thereby, the top surface and bottom surface of the LED assembly 11A can be masked at the same time as the LED assembly 11A is fixed.

Subsequently, a silicone resin is sprayed with a sprayer (spray) SP as an adhesive of a coating adhesive surface (side wall) of the LED assembly 11A. The cut coating plate 17 (alumina + Al/TiW) is adsorbed by a coating chuck CP and attached to the coating adhesive surface on which the adhesive is sprayed. In this case, the coating plate 17 is instantaneously heated (pre-heated) and temporarily adhered.

Next, the LED assembly 11A is rotated by 180° to temporarily adhere the coating plate 17 to a surface (facing surface) opposite to a surface to which the coating plate 17 has been attached. The coating plate 17 is adhered to the remaining two surfaces in the same manner. Finally, the coating plate 17 was formed on four side surfaces of the LED assembly 11A by heating at 180°C for 5 minutes.

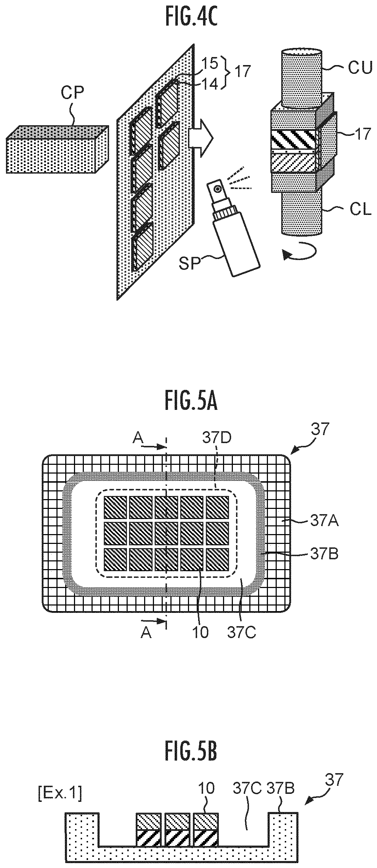

FIGS. 4A to 4C are views illustrating a manufacturing method of the semiconductor light emitting device 10 when the inner coating film 14 of the coating plate 17 is a dielectric multilayer film.

FIG. 4A is a view illustrating the LED assembly 11A formed in the same manner as in a case illustrated in FIG. 3A. As illustrated in FIG. 4B, aluminum (Al) 14 is vapor-deposited on a transparent resin film FM, and TiO₂/SiO₂ is stacked in multiple layers on the aluminum (Al) 14 to form a dielectric multilayer film 15 that reflects visible light (left side in FIG. 4B).

Subsequently, a coating plate 17 (dielectric multilayer film plate) is formed by dicing according to a size of the side wall of an LED assembly 11A (right side of FIG. 4B). In this case, the dielectric multilayer film 15 and the Al 14 are cut so as not to completely cut the film FM.

Next, as illustrated with reference to FIG. 3C, the LED assembly 11A is set between an upper chuck CU and a lower chuck CL. Thereby, the top surface and bottom surface of the LED assembly 11A are masked at the same time as the LED assembly 11A is fixed.

Subsequently, a silicone resin is sprayed onto the coating adhesive surface (side wall) of the LED assembly 11A with the sprayer SP. The dielectric multilayer film plate 17 is pressed against and adhered to the coating adhesive surface of the LED assembly 11A. At the same time, the dielectric multilayer film plate 17 is peeled from the resin film FM by irradiating with a laser.

Next, the LED assembly 11A is rotated by 180° to temporarily adhere the coating film to a surface (facing surface) opposite to a surface to which the coating plate 17 has been attached. The dielectric multilayer film plate 17 is adhered to the remaining two surfaces in the same manner. Finally, the dielectric multilayer film plate (coating plate) 17 was formed on four side surfaces of the LED assembly 11A by heating at 180°C for 5 minutes.

FIGS. 5A to 5D are views schematically illustrating a difference between the semiconductor light emitting device 10 of the present embodiment (Ex. 1) and a semiconductor light emitting device of Comparative Examples 1 and 2 (Comp. 1 and Comp. 2).

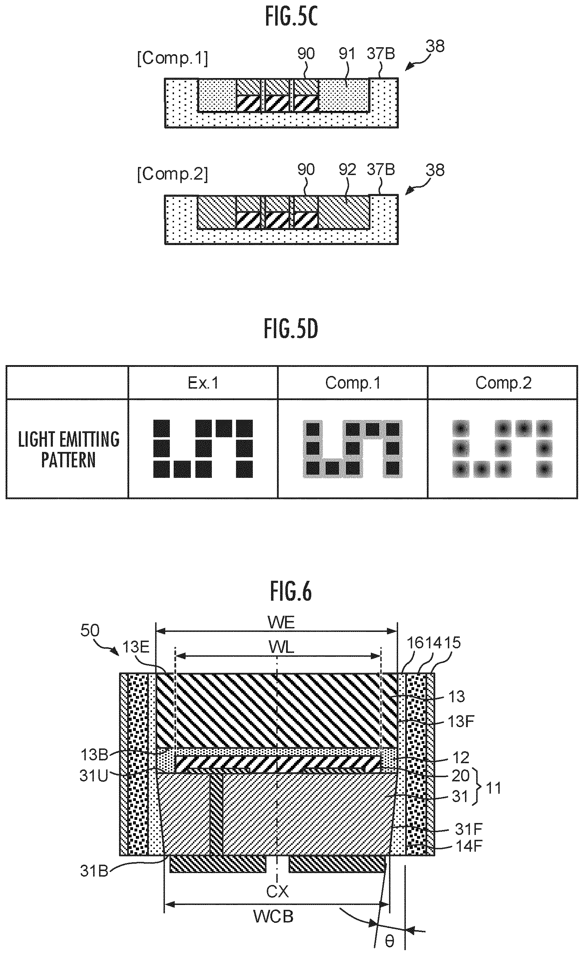

FIG. 5A is a top view illustrating a semiconductor light emitting module 37 in which semiconductor light emitting devices are arranged in a 5 x 3 arrangement. The semiconductor light emitting module 37 has a base 37A, a frame (frame body) 37B provided on the base 37A, and a recessed portion 37C in the frame 37B, and the semiconductor light emitting devices are arranged in the recessed portion 37C to be adjacent to each other at narrow intervals in a region 37D. The base 37A is provided with an electrode for supplying a current to each of the semiconductor light emitting devices, but the electrode is not illustrated. In addition, FIGS. 5B and 5C do not illustrate the base 37A outside the frame 37B.

FIG. 5B is a sectional view illustrating a cross section taken along line A-A in FIG. 5A and illustrates an application example of the semiconductor light emitting device 10 of the present embodiment (Ex. 1). The semiconductor light emitting devices 10 of the present embodiment are arranged in the recessed portion 37C of the semiconductor light emitting module 37 and are mounted on a wiring substrate (not illustrated), but a resin or the like for shielding light is not provided between the semiconductor light emitting devices 10. That is, a light shielding body such as a resin is not required between the semiconductor light emitting devices 10, and each of the semiconductor light emitting devices 10 is mounted separately by an air gap.

FIG. 5C illustrates a semiconductor light emitting module 38 of a Comparative Example, in which the semiconductor light emitting module 38 is the same as the semiconductor light emitting module 37 illustrated in FIG. 5A, but has semiconductor light emitting devices 90 of Comparative Examples 1 and 2 (Comp. 1 and Comp. 2) arranged in the frame.

The semiconductor light emitting device 90 of the Comparative Example is a semiconductor light emitting device in which the inner coating film 14 and the outer coating film 15 are not provided on side surfaces thereof, and side surfaces of the LED element 11 and light guide member 13 are exposed. The recessed portion 37C is filled with a resin as a light shielding material between each of the semiconductor light emitting devices. The recessed portion 37C is preferably filled with the light shielding resin so as to reach an upper surface of the semiconductor light emitting device 90.

More specifically, in Comparative Example 1 (Comp. 1), the recessed portion 37C is filled with a light-reflective resin 91 as a light shielding material. Specifically, the recessed portion 37C is filled with a white resin 91 in which TiO2 particles are contained in a silicone resin.

In Comparative Example 2 (Comp. 2), the recessed portion 37C is filled with a light-absorptive resin (grey resin) 92 as a light shielding material. Specifically, the recessed portion 37C is filled with the grey resin 92 in which TiO2 particles and carbon black are contained in the silicone resin.

FIG. 5D is a view schematically illustrating a difference in a light emitting display pattern between the semiconductor light emitting module 37 used in the semiconductor light emitting device 10 of the present embodiment (Ex. 1) and the semiconductor light emitting module 38 used in semiconductor light emitting devices 90 of Comparative Examples 1 and 2 (Comp. 1 and Comp. 2).

In addition, FIG. 5D schematically illustrates a state of brightness (light/dark) of the semiconductor light emitting device 90 when 11 of 15 semiconductor light emitting devices arranged in 5 x 3 arrangement are fit in an S shape. In order to easily illustrate the state of brightness (light/dark), the lighter the brightness, the darker the brightness.

As in Comparative Example 1 (Comp. 1), when a light shielding material 91 is a white resin, a display blurs due to light leaking from an outer peripheral portion of the light guide member (phosphor plate). In addition, crosstalk also occurs between the semiconductor light emitting devices 90.

As in Comparative Example 2 (Comp. 2), when a light shielding material 92 is a grey resin, the light shielding material 92 causes a large amount of light absorption and a large reduction in brightness of the outer peripheral portion of the light guide member (phosphor plate).

On the other hand, in the semiconductor light emitting device 10 of the present embodiment (Ex. 1), light cannot leak to the side and upper end of the device and a light emitting pattern (display pattern) with high contrast can be made. In addition, even when the semiconductor light emitting devices are lit separately, the semiconductor light emitting devices can be mounted with high density because an adjacent distance between the semiconductor light emitting devices without crosstalk can be reduced.

A case where the above-described semiconductor light emitting module 37 is not provided with a resin or the like for shielding light between the plurality of semiconductor light emitting devices 10 arranged side by side with a gap (that is, when the gap is a space), has been described, but a light shielding resin may be provided between the plurality of semiconductor light emitting devices 10. In this case, it is possible to obtain a semiconductor light emitting module capable of producing the light emitting patterns (display patterns) with higher contrast and no crosstalk.

According to the semiconductor light emitting device of the first embodiment, it is possible to provide a semiconductor light emitting device having high performance and high light emitting efficiency, in which light leakage from the side surface of the light emitting device and the upper end on a side of the light emission surface to the outside of the light emitting device and incidence of external light are extremely suppressed. In addition, it is possible to provide a semiconductor light emitting device having excellent airtightness and high reliability.

### [Second Embodiment]

FIG. 6 is a sectional view schematically illustrating a cross section of a semiconductor light emitting device 50 according to a second embodiment of the present invention. FIG. 6 illustrates a cross section including a center line (line A-A illustrated in FIG. 1A) of the semiconductor light emitting device 50, in a plane perpendicular to the semiconductor light emitting device 50.

In the semiconductor light emitting device 50, the light guide member 13 has a rectangular shape, and the bottom surface 13B of the light guide member 13 is larger than the outer edge of the LED semiconductor layer 20. In addition, the support substrate 31 of the LED element 11 has an inversed truncated pyramid shape, that is, a truncated pyramid shape of which an upper surface (surface on a side of the light guide member 13) 31U of the support substrate 31 is larger than a bottom surface 31B. Therefore, a width WE of the light guide member 13 is larger than a width WCB of the bottom surface 31B of the support substrate 31 (WE > WCB).

The light guide member 13 and the support substrate 31 are aligned (that is, coaxial) with respect to a central axis CX, and the central axis CX constitutes a central axis of the semiconductor light emitting device 50.

As in the first embodiment, the light guide member 13 has a size and arrangement such that the light guide member 13 includes the LED semiconductor layer 20 when viewed in the vertical direction of the LED semiconductor layer 20 (when viewed from above). That is, WE > WL, in which a width of the LED semiconductor layer 20 is defined as WL.

The support substrate 31 having an inversed truncated pyramid shape is configured to have an angle θ formed by the side surface 31F of the support substrate 31 and the side surface 13F of the light guide member 13 (or an angle θ formed by the side surface 31F and an inner surface 14F of the inner coating film 14). That is, the support substrate 31 has a tapered side surface 31F inclined at the angle θ.

As described above, even if the support substrate has a tapered side surface inclined so that an area thereof is reduced from the top surface to the bottom surface, the side wall adhesive layer 16 interpolates the support substrate, so that the support substrate 31 is not exposed, thereby preventing short circuits of the semiconductor light emitting device 50.

According to the semiconductor light emitting device of the present embodiment, similarly to the semiconductor light emitting device of the first embodiment, it is possible to provide a semiconductor light emitting device having high performance and high light emitting efficiency, in which light leakage from the side surface of the light emitting device and the upper end on a side of the light emission surface to the outside of the light emitting device and incidence of external light are extremely suppressed. In addition, it is possible to provide a semiconductor light emitting device having excellent airtightness and high reliability.

### [Third Embodiment]

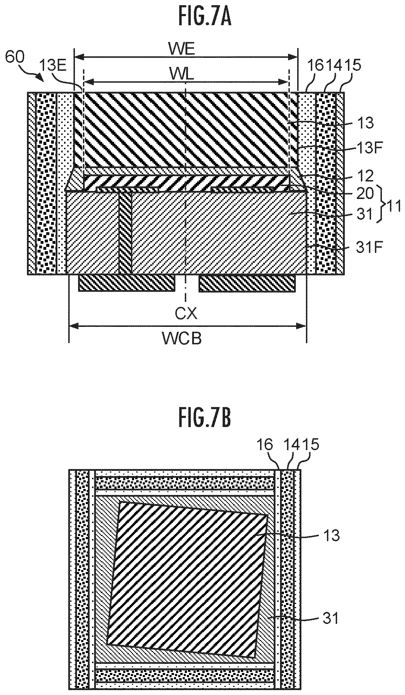

FIG. 7A is a sectional view schematically illustrating a cross section of a semiconductor light emitting device 60 according to a third embodiment of the present invention. FIG. 7A illustrates a cross section including a center line (line A-A illustrated in FIG. 1A) of the semiconductor light emitting device 60, in a plane perpendicular to the semiconductor light emitting device 50. In addition, FIG. 7B is a top view schematically illustrating the semiconductor light emitting device 60 when viewed from above.

In the semiconductor light emitting device 60, the light guide member 13 and the support substrate 31 have a rectangular shape. In the present embodiment, the width WE of the light guide member 13 is smaller than the width WCB of the bottom surface 31B of the support substrate 31 (WE < WCB).

The light guide member 13 has a size and arrangement such that the light guide member 13 includes the LED semiconductor layer 20 when viewed in the vertical direction of the LED semiconductor layer 20 (when viewed from above). That is, WE > WL, in which a width of the LED semiconductor layer 20 is defined as WL.

A size of the support substrate 31 can be smaller than the size of the light guide member 13. FIG. 7B schematically illustrates a case where the light guide member 13 obliquely adheres to the support substrate 31 when viewed from above, but the coating plate 17 can be reliably adhered even when the light guide member 13 is adhered to the support substrate 31 in a displaced manner.

According to the semiconductor light emitting device of the present embodiment, similarly to the semiconductor light emitting device of the above-described embodiment, it is possible to provide a semiconductor light emitting device having high performance and high light emitting efficiency, in which light leakage from the side surface and upper end of the light emitting device to the outside of the light emitting device and incidence of external light are extremely suppressed. In addition, it is possible to provide a semiconductor light emitting device having excellent airtightness and high reliability.

### [Fourth Embodiment]

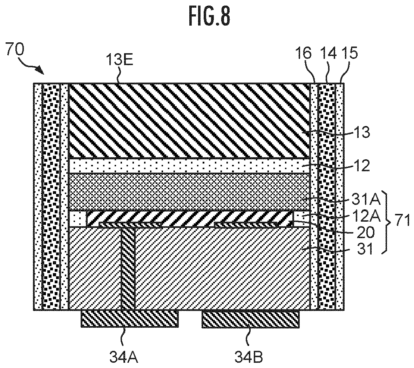

FIG. 8 is a sectional view schematically illustrating a configuration of a semiconductor light emitting device 70 according to a fourth embodiment of the present invention. The semiconductor light emitting device 70 is different from the semiconductor light emitting device 10 illustrated in FIG. 1B in that an LED element 71 is used instead of the LED element 11.

More specifically, the above-described LED element 11 uses the LED semiconductor layer 20 which is a thin-film LED. However, the LED element 71 of the present embodiment has a configuration in which the LED semiconductor layer 20 epitaxially grown on the transparent growth substrate 31A is provided and a surface side of the LED semiconductor layer 20 is attached to the support substrate 31. In the LED element 71, a LED chip formed of the growth substrate 31A and the LED semiconductor layer 20 is adhered to the support substrate 31 by the element adhesive layer 12A.

Specifically, the semiconductor light emitting device 70 includes the LED element 71 and the light guide member 13 adhered onto the growth substrate 31A of the LED element 71 by an element adhesive layer 12 formed of an adhesive. In addition, the semiconductor light emitting device 70 has the coating plate 17 adhered by the side wall adhesive layer 16 so as to cover the side surface of the LED element 71 and the light guide member 13.

In the present embodiment, the side surface of the growth substrate 31A of the LED element 71 is also covered with the coating plate 17 adhered by the side wall adhesive layer 16 to shield light.

According to the present embodiment, as in the semiconductor light emitting device of the above embodiment, it is possible to provide a semiconductor light emitting device having excellent airtightness and high reliability, in which light leakage from the side surface and upper end of the light emitting device to the outside of the light emitting device is extremely suppressed. In addition, it is possible to provide a simple semiconductor light emitting device having a low cost without the need to remove the growth substrate.

In the above embodiment, a case where a semiconductor light emitting element substrate, the light guide member, and the like have a rectangular shape or a truncated pyramid shape has been described by way of example, but the present invention is not limited thereto. It is possible to appropriately modify and apply a polygonal column shape, a cylindrical shape, polygonal truncated pyramid shape, a truncated cone shape, and the like according to an arrangement form, such as a case where the semiconductor light emitting element substrate and the light guide member are arranged adjacent to each other on the circuit board.

Further, a case where the coating plate 17 is formed of the first coating film (inner coating film) and the second coating film (outer coating film) 15 has been described, but as described above, the coating plate 17 may be formed of only the first coating film.

As described in detail above, according to the present invention, it is possible to provide a semiconductor light emitting device having excellent airtightness and high reliability by extremely suppressing light leakage from the side surface of the light emitting device and the upper end on the light emission surface side and incident of external light to the outside of the light emitting device.

Further, it is possible to provide a semiconductor light emitting module having high contrast and excellent light shielding property, airtightness, fixing stability, and reliability, in which light leakage from the adjacent light emitting devices and crosstalk of light from the adjacent light emitting devices are extremely suppressed. In addition, it is possible to provide a semiconductor light emitting module which can prevent secondary light emission due to incident external light and reliably turn off the semiconductor light emitting device that is not driven so as to be suitable for high-density arrangement and local dimming lighting.

### Description of Reference Numerals

10, 50, 60,70: semiconductor light emitting device
11, 71: semiconductor light emitting element
11A: light emitting element assembly
12: element adhesive layer
13: light guide member
13E: light emission surface
13F: side surface of light guide member 13
14: first coating film
15: second coating film
16: side wall adhesive layer
20: light emitting semiconductor layer
21: n-type semiconductor layer
22: light emitting layer
23: p-type semiconductor layer
25A: p-electrode
25B: n-electrode
26, 27: bonding layer
31: support substrate
31B: bottom surface of support substrate
31F: side surface of support substrate
33: conductive via
34A: anode electrode
34B: cathode electrode
CX: central axis of semiconductor light emitting device
WB: width of bottom surface of light guide member
WCB: width of bottom surface of support substrate
WL: width of light emitting semiconductor layer

## Claims

1. A semiconductor light emitting device comprising:
a light emitting element assembly including a semiconductor light emitting element including a support substrate and a light emitting semiconductor layer provided on the support substrate, and a light guide member adhered to the semiconductor light emitting element by an element adhesive layer; and
a first coating film adhered to a side surface of the light emitting element assembly by a side wall adhesive layer and formed of an inorganic material, which is a light reflector configured to cover the side surface.

2. The semiconductor light emitting device according to claim 1, wherein the first coating film is an alumina plate.

3. The semiconductor light emitting device according to claim 2, wherein the first coating film is a ceramic binder or a silicate-based binder having a white ceramic.

4. The semiconductor light emitting device according to claim 3, wherein the white ceramic contains any one of alumina, zirconia, and magnesia.

5. The semiconductor light emitting device according to any one of claims 2 to 4, wherein the side wall adhesive layer is a transparent resin or a white resin.

6. The semiconductor light emitting device according to claim 1, wherein the first coating film is a dielectric multilayer film.

7. The semiconductor light emitting device according to claim 6, wherein the side wall adhesive layer is a transparent resin.

8. The semiconductor light emitting device according to any one of claims 1 to 7, further comprising a second coating film formed of a light shielding inorganic material and making contact with an outside of the first coating film.

9. The semiconductor light emitting device according to any one of claims 1 to 6, wherein the semiconductor light emitting element is a thin-film light emitting semiconductor layer attached onto the support substrate.

10. The semiconductor light emitting device according to any one of claims 1 to 9, wherein the light guide member is formed to have a size and arrangement such that a bottom surface of the light guide member includes a light emitting layer of the semiconductor light emitting element, when viewed from above.

11. The semiconductor light emitting device according to any one of claims 1 to 10, wherein the support substrate has tapered side surfaces that are inclined so that an area decreases from a top surface to a bottom surface of the support substrate.

12. The semiconductor light emitting device according to any one of claims 1 to 11, wherein the light guide member and the support substrate are arranged to be aligned with a central axis perpendicular to the semiconductor layer, and the support substrate is smaller than the light guide member.

13. The semiconductor light emitting device according to any one of claims 1 to 8 and 10 to 12, wherein the semiconductor light emitting element has a growth substrate, and the growth substrate is adhered to the light guide member by an adhesive layer.

14. A semiconductor light emitting module having a plurality of the semiconductor light emitting devices according to any one of claims 1 to 13, which are arranged side by side with a gap,
wherein the gap between the semiconductor light emitting devices is a space.

## Amended claims

### Amended claims under Art. 19.1 PCT

1. A semiconductor light emitting device comprising:
a light emitting element assembly including a semiconductor light emitting element including a support substrate and a light emitting semiconductor layer provided on the support substrate, and a light guide member adhered to the semiconductor light emitting element by an element adhesive layer; and
a first coating film adhered to a side surface of the light emitting element assembly by a side wall adhesive layer and formed of an inorganic material, which is a light reflector configured to cover the side surface,
wherein the first coating film is a dielectric multilayer film or a coating plate.

2. The semiconductor light emitting device according to claim 1, wherein the first coating film is an alumina plate.

3. The semiconductor light emitting device according to claim 2, wherein the first coating film is a ceramic binder or a silicate-based binder having a white ceramic.

4. The semiconductor light emitting device according to claim 3, wherein the white ceramic contains any one of alumina, zirconia, and magnesia.

5. The semiconductor light emitting device according to any one of claims 2 to 4, wherein the side wall adhesive layer is a transparent resin or a white resin.

6. The semiconductor light emitting device according to claim 1, wherein the first coating film is a dielectric multilayer film plate.

7. The semiconductor light emitting device according to claim 6, wherein the side wall adhesive layer is a transparent resin.

8. The semiconductor light emitting device according to any one of claims 1 to 7, further comprising a second coating film formed of a light shielding inorganic material and making contact with an outside of the first coating film.

9. The semiconductor light emitting device according to any one of claims 1 to 6, wherein the semiconductor light emitting element is a thin-film light emitting semiconductor layer attached onto the support substrate.

10. The semiconductor light emitting device according to any one of claims 1 to 9, wherein the light guide member is formed to have a size and arrangement such that a bottom surface of the light guide member includes a light emitting layer of the semiconductor light emitting element, when viewed from above.

11. The semiconductor light emitting device according to any one of claims 1 to 10, wherein the support substrate has tapered side surfaces that are inclined so that an area decreases from a top surface to a bottom surface of the support substrate.

12. The semiconductor light emitting device according to any one of claims 1 to 11, wherein the light guide member and the support substrate are arranged to be aligned with a central axis perpendicular to the semiconductor layer, and the support substrate is smaller than the light guide member.

13. The semiconductor light emitting device according to any one of claims 1 to 8 and 10 to 12, wherein the semiconductor light emitting element has a growth substrate, and the growth substrate is adhered to the light guide member by an adhesive layer.

14. A semiconductor light emitting module having a plurality of the semiconductor light emitting devices according to any one of claims 1 to 13, which are arranged side by side with a gap,
wherein the gap between the semiconductor light emitting devices is a space.
